(19) Europäisches Patentamt / European Patent Office / Office européen des brevets

(11) **EP 2 901 503 B1**

(12) **EUROPÄISCHE PATENTSCHRIFT**

(45) Veröffentlichungstag und Bekanntmachung des Hinweises auf die Patenterteilung:
**27.04.2016 Patentblatt 2016/17**

(21) Anmeldenummer: **14711704.8**

(22) Anmeldetag: **05.03.2014**

(51) Int Cl.:
**H01L 35/32** (2006.01)

(86) Internationale Anmeldenummer:
**PCT/EP2014/054286**

(87) Internationale Veröffentlichungsnummer:
**WO 2014/135600 (12.09.2014 Gazette 2014/37)**

(54) **TRÄGERELEMENT UND MODUL**

CARRIER ELEMENT AND MODULE

ÉLÉMENT DE SUPPORT ET MODULE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.03.2013 DE 102013102240**

(43) Veröffentlichungstag der Anmeldung:
**05.08.2015 Patentblatt 2015/32**

(73) Patentinhaber: **O-Flexx Technologies GmbH**
**47059 Duisburg (DE)**

(72) Erfinder:
• **SPAN, Gerhard**
  **A-6112 Wattens (AT)**
• **VITEK, Christian**
  **87737 Boos-Reichau (DE)**
• **HOPPE, Stefan**
  **46286 Dorsten (DE)**

(74) Vertreter: **Kohlmann, Kai**
**Donatusstraße 1**
**52078 Aachen (DE)**

(56) Entgegenhaltungen:
| CH-A5- 677 421 | DE-A1- 10 045 419 |
| DE-A1-102008 032 856 | DE-A1-102011 008 378 |
| US-A- 3 561 903 | US-A1- 2006 151 021 |
| US-A1- 2007 125 413 | |

**Beschreibung**

Die Erfindung betrifft ein Trägerelement umfassend eine Anbindung an eine Wärmequelle und eine Anbindung an eine Wärmesenke sowie ein auf dem Trägerelement zwischen der Anbindung an die Wärmequelle und der Anbindung an die Wärmesenke angeordnetes thermoelektrisches Dünnschichtelement. Außerdem betrifft die Erfindung ein Modul mit mehreren Trägerelementen.

Die direkte Wandlung von Wärme in elektrische Energie ist mit einem als Generator betriebenen thermoelektrischen Element möglich. Man verwendet hierfür vorzugsweise unterschiedlich dotierte Halbleitermaterialien, wodurch sich die Effizienz gegenüber Thermoelementen mit zwei unterschiedlichen und an einem Ende miteinander verbundenen Metallen wesentlich steigern lässt. Gebräuchliche Halbleitermaterialien sind $Bi_2Te_3$, $PbTe$, $SiGe$, $BiSb$ und $FeSi_2$. Um ausreichend hohe Spannungen zu erzeugen, ist in einem thermoelektrischen Element üblicherweise eine Vielzahl von Thermopaaren elektrisch in Reihe geschaltet.

Die Wirkungsweise eines thermoelektrischen Elementes beruht auf dem thermoelektrischen Effekt, nachfolgend als Seebeck-Effekt bezeichnet. Beim Seebeck-Effekt entsteht zwischen zwei Punkten eines elektrischen Leiters bzw. Halbleiters, die eine verschiedene Temperatur haben, eine elektrische Spannung. Die entstehende Spannung ist bestimmt durch

$$U_{Seebeck} = \alpha \times \Delta T$$

mit

$\Delta T$   Temperaturdifferenz zwischen zwei Punkten des Leiter/Halbleiters an den Kontaktstellen,
$\alpha$   Seebeck-Koeffizient.

Herkömmliche thermoelektrische Elemente bestehen aus mehreren Quadern aus thermoelektrisch aktivem Halbleitermaterial, die abwechselnd oben und unten durch Metallbrücken elektrisch leitend miteinander verbunden sind. Die Metallbrücken bilden zugleich die thermischen Kontaktflächen und sind durch eine aufliegende Keramikplatte isoliert.

Darüber hinaus sind aus dem Stand der Technik thermoelektrische Dünnschichtelemente bekannt:

Aus der DE 10 2006 031 164 A1 ist ein thermoelektrisches Dünnschichtelement mit einer Trägerstruktur bekannt, auf der mehrere Thermoschenkel aus einem ersten leitfähigen Material und mehrere Thermoschenkel aus einem zweiten leitfähigen Material aufgebracht sind, wobei das erste und zweite leitfähige Material eine unterschiedliche Leitfähigkeit aufweisen und die Thermoschenkel derart miteinander elektrisch gekoppelt sind, dass jeweils zwei Thermoschenkel ein Thermopaar bilden, wobei sämtliche Thermoschenkel aus dem ersten und zweiten leitfähigen Material nebeneinander auf der Trägerstruktur angeordnet sind. Die kalte Seite des thermoelektrischen Dünnschichtelementes befindet sich auf einer Seite der elektrisch leitfähigen ersten und zweiten Materialien und die heiße Seite auf der gegenüberliegenden Seite der elektrisch leitfähigen ersten und zweiten Materialien.

Aus der DE 101 22 679 A1 ist schließlich ein thermoelektrisches Dünnschichtelement bekannt, das ein flexibles Substratmaterial aufweist, auf dem Dünnschicht-Thermopaare aufgebracht sind. Die Dünnschicht-Thermopaare werden aus einer Materialkombination von zwei unterschiedlichen Materialien gebildet, wobei das erste und das zweite Material derart eingerichtet und derart miteinander thermisch gekoppelt sind, dass sie zusammen ein Thermopaar bilden. Die beiden Materialien werden auf die flexible Folie aufgedruckt oder mittels üblicher Abscheideverfahren abgeschieden. Es werden nebeneinander angeordnete Streifen beispielsweise aus Nickel als erstem Material und Streifen aus Chrom als zweitem Material gebildet, wobei die Streifen an ihren Enden jeweils paarweise über eine Kopplungsstruktur aus dem zweiten Material elektrisch miteinander verbunden sind. Durch die gekoppelten Streifen wird eine Serienschaltung von mehreren Thermopaaren auf einer kleinen Fläche gebildet. Die hohe Anzahl der Dünnschicht-Thermopaare führt zu einer hohen Ausgangsspannung des Thermoelementes. Die elektrischen Kopplungsstrukturen auf der einen Seite des thermoelektrischen Dünnschichtelementes bilden dessen heiße Seite, die Kopplungsstrukturen auf der gegenüberliegenden Seite des thermoelektrischen Dünnschichtelementes bilden dessen kalte Seite aus, wobei die heiße Seite mit einem Ankopplungselement an eine Wärmequelle und die kalte Seite mit einer Wärmesenke verbunden ist.

Aus der DE 10 2008 032 856 A1 ist ein Wärmeüberträger für ein thermoelektrisches Dünnschichtelement mit einer heißen und einer kalten Seite bekannt, wobei das flexible Dünnschichtelement an der heißen Seite zwischen zwei Profilen eines Ankopplungselementes und an der kalten Seite zwischen zwei Profilen einer Wärmesenke eingeklemmt ist. Die Wärmesenke wird im dargestellten Ausführungsbeispiel von den Klemmprofilen gebildet, an denen sich von den Klemmprofilen weg erstreckende Kühlrippen angeordnet sind.

Gute thermoelektrische Materialien sind spröde und mechanisch nur auf Druck belastbar. Zug- und Scherbelastung führen daher nicht zu einer plastischen Verformung, sondern zum Bruch der thermoelektrisch aktiven Materialien.

Um die thermoelektrisch aktiven Materialien herkömmlicher thermoelektrischer Elemente trotz unterschiedlicher Ausdehnungen der Wärmequelle und der Wärmesenke nach Möglichkeit nur auf Druck zu belasten, erfolgt die Anbindung der Keramikplatte auf der heißen Seite an die Wärmequelle gleitend. Der im Interesse eines hohen Wirkungsgrades des thermoelektrischen Elementes angestrebte geringe thermische Widerstand zwischen der Wärmequelle und der Keramikplatte erfordert grundsätzlich eine sehr hohe Anpresskraft, die sich jedoch aufgrund der zum Ausgleich unterschiedlicher Ausdehnungen erforderlichen Gleitlagerung verbietet. Um insoweit einen optimalen Kompromiss zu finden, ist über die gesamte Oberfläche der gleitgelagerten Keramikplatte ein gleichförmiger Kraftschluss erforderlich, der nur mit außerordentlich großem, bisher nicht automatisierbaren Herstellungsaufwand realisierbar ist.

Aus der DE 10 2011 008 378 A1 ist ein thermoelektrisches Modul bekannt, dass sich in einer Längsrichtung erstreckt, mit einem Außenrohr und einem innerhalb des Außenrohrs angeordneten Innenrohr sowie einem dazwischen angeordneten Zwischenraum. In dem Zwischenraum sind eine erste streifenförmige Struktur und eine zweite streifenförmige Struktur vorgesehen sind, wobei die erste streifenförmige Struktur sich ausgehend von einer ersten Anbindung am Innenrohr und die zweite streifenförmige Struktur sich ausgehend von einer zweiten Anbindung am Außenrohr in jeweils entgegen gesetzten Richtungen in einer Umfangsrichtung der Rohre oder deren Längsrichtung erstrecken. Die streifenförmigen Strukturen überdecken sich teilweise in Umfangsrichtung oder in Längsrichtung, wobei im Bereich der Überdeckung zwischen der ersten und der zweiten streifenförmigen Struktur ein Paar Halbleiterelemente angeordnet ist. Das Außenrohr und das Innenrohr sind so zueinander angeordnet, dass eine thermische Ausdehnung des Moduls in erster Linie durch eine relative Bewegung des Außenrohres gegenüber dem Innenrohr kompensiert wird. Außerdem sind die streifenförmigen Strukturen federnd angeordnet.

Ausgehend von diesem Stand der Technik liegt der Erfindung die Aufgabe zu Grunde, ein Trägerelement mit einem auf dem Trägerelement angeordneten thermoelektrischen Dünnschichtelement vorzuschlagen, das für die Befestigung des Dünnschichtelementes besonders geeignet ist und das bei guter thermischer Anbindung an eine Wärmequelle und Wärmesenke schädliche Zug- und Scherbeanspruchungen in dem thermoelektrischen Dünnschichtelement, insbesondere in dem thermoelektrisch aktiven Material, vermeidet.

Diese Aufgabe wird bei einem Trägerelement der eingangs erwähnten Art dadurch gelöst, dass

- das Trägerelement eine Platte zum Aufbringen des thermoelektrischen Dünnschichtelements und an der Platte angeordnete Verbindungselemente für die Anbindung des Trägerelementes an die Wärmequelle und die Wärmesenke aufweist sowie

- mindestens ein elastischer und/oder flexibler Kompensationsabschnitt des Trägerelementes zwischen der Anbindung an die Wärmequelle und der Anbindung an die Wärmesenke derart eingerichtet ist, dass er unterschiedliche Ausdehnungen der Wärmequelle und der Wärmesenke durch eine Formänderung des Kompensationsabschnitts ausgleicht.

Die unterschiedlichen Ausdehnungen der Wärmequelle und der Wärmesenke werden von dem Kompensationsabschnitt vollständig durch Formänderung aufgenommen, so dass die übrigen Bereiche des Trägerelementes aufgrund der thermisch unterschiedlichen Ausdehnungen nicht verformt werden. Insbesondere das für Scherbelastungen empfindliche thermoelektrisch aktive Material wird in den übrigen Bereichen angeordnet und dadurch keinen Scherbelastungen ausgesetzt.

Der erfindungsgemäß vorgesehene Kompensationsabschnitt erlaubt eine stoffschlüssige Anbindung des Trägerelementes an die Wärmequelle und die Wärmesenke. Durch eine stoffschlüssige Anbindung entfällt die Notwendigkeit, große Druckkräfte zwischen Wärmequelle bzw. Wärmesenke und der Anbindung des Trägerelements an die Wärmequelle bzw. Wärmesenke aufzubauen, um einen geringen thermischen Widerstand zu erzielen. Außerdem erlaubt die stoffschlüssige Anbindung größere Fertigungstoleranzen sowohl des Trägerelementes als auch der Wärmequelle bzw. Wärmesenke. Etwaige Fertigungstoleranzen können beispielsweise durch einen Kleber oder ein Lot zur Herstellung der stoffschlüssigen Verbindung ausgeglichen werden.

Das Trägerelement weist eine Platte zum Aufbringen des thermoelektrischen Dünnschichtelementes auf. Die ebene Oberfläche ist für die Befestigung des thermoelektrischen Dünnschichtelementes besonders geeignet. Darüber hinaus lässt sich in eine relativ dünne Platte der Kompensationsabschnitt unmittelbar, insbesondere durch Prägen einbringen. Für die vorzugsweise stoffschlüssige Anbindung des Trägerelementes an die Wärmequelle und die Wärmesenke sind an der Platte Verbindungselemente angeordnet.

Um eine hohe Zyklenfestigkeit zu erreichen, weist jeder Kompensationsabschnitt vorzugsweise ein linearelastisches Verhalten auf.

Der Kompensationsabschnitt kann durch Prägung erzeugte Erhebungen und/oder Vertiefungen aufweisen, um die Belastungen aufgrund der unterschiedlichen Ausdehnungen der Wärmequelle und Wärmesenke auszugleichen.

Vorzugsweise weist der Kompensationsabschnitt jedoch eine genoppte Struktur mit einer zweidimensionalen Anordnung von Erhebungen und Vertiefungen auf. Eine solche Noppenstruktur lässt Kompensationsbewegungen der in dem Kompensationsabschnitt auftretenden Kräfte in allen Raumrichtungen zu.

Der elastische Kompensationsabschnitt kann darüber hinaus nach Art eines Rohrkompensators als elastischer Balg - auch als Faltenbalg bezeichnet- ausgestaltet sein. Jeder Balg kann mit mindestens einem, vorzugsweise mehreren Schlitzen versehen sein, die sich quer zum Verlauf der Falten des Balgs erstrecken. Sofern die Falten des Balgs rechtwinklig zur Hauptausdehnungrichtung der Wärmequelle verlaufen, werden durch die Schlitze Ausdehnungen der Wärmequelle gegenüber der Wärmesenke senkrecht zur Hauptausdehnungsrichtung kompensiert. Ähnlich wie der mit Noppenstruktur versehene Kompensationsabschnitt lässt auch der geschlitzte Balg Kompensationsbewegungen der in dem Kompensationsabschnitt auftretenden Kräfte in allen Raumrichtungen zu.

Der elastische Kompensationsabschnitt kann aus demselben Material wie die übrigen Bereiche des Trägerelementes bestehen. Als Werkstoff für das Trägerelement und den geprägten elastischen Kompensationsabschnitt kommen beispielsweise Metalle zum Einsatz, die insbesondere aggressiven Medien und hohen Temperaturen gut standhalten können. Der elastische Kompensationsabschnitt kann jedoch abweichend zu den übrigen Bereichen des Trägerelementes auch aus Weichstoff, wie technischen Geweben oder Elastomeren bestehen.

Das thermoelektrische Dünnschichtelement weist ein Substrat und auf dem Substrat aufgebrachtes thermoelektrisch aktives Material auf. Das thermoelektrisch aktive Material weist eine Schichtdicke von maximal 150 $\mu$m auf.

Das Substrat ist elektrisch isolierend, um voneinander getrennte Bereiche aus thermoelektrisch aktivem Material abwechselnd auf der heißen und kalten Seite des Dünnschichtelementes durch auf dem Substrat aufgebrachte metallisierte Bereiche elektrisch leitend miteinander zu verbinden. Um einen Wärmefluss von der heißen zur kalten Seite durch das Substrat hindurch zu vermeiden, weist das Material des Substrats eine geringe Wärmeleitfähigkeit auf. Die Bereiche aus thermoelektrisch aktivem Material sind vorzugsweise in Reihe geschaltet.

Das Substrat kann flexibel, beispielsweise als Polyimid-Folie ausgebildet sein. Das als Folie ausgebildete Substrat ist vorzugsweise streifenförmig mit der heißen und kalten Seite an gegenüberliegenden Längsseiten des Streifens. Die flexible Folie kann auch dem Kompensatorabschnitt ganz oder teilweise überlappend auf dem Trägerelement angeordnet und befestigt werden. Bei der Anordnung und Befestigung der Folie auf dem Trägerelement ist jedoch darauf zu achten, dass sich kein thermoelektrisch aktives Material im Bereich oberhalb des Kompensatorabschnitts befindet.

Das Substrat kann auch aus einem biegesteifen Material bestehen. In diesem Fall befindet sich jeder Kompensatorabschnitt in einem nicht mit dem Substrat überlappenden Bereich des Trägerelementes. Andernfalls würde das elastische und/oder flexible Verhalten des Kompensatorabschnitts durch das biegesteife Material des Substrats unterbunden.

Das thermoelektrische Dünnschichtelement ist stoffschlüssig mit einer insbesondere ebenen Oberfläche des Trägerelements verbunden, beispielsweise durch Verkleben oder Verlöten. Um das Verlöten zu erleichtern, kann die zu verlötende Rückseite des Substrats metallisiert sein.

Sofern auf dem als Platte ausgestalteten Tragelement ein thermoelektrisches Dünnschichtelement mit einem flexiblen Substrat angebracht ist, kann die Platte und das Substrat in den überlappenden Abschnitten miteinander fluchtende Schlitze aufweisen, die in den überlappenden Abschnitten auftretende Spannungen ausgleichen. Die Schlitze in der Platte und dem Substrat verlaufen zu diesem Zweck insbesondere senkrecht zur Hauptausdehnungsrichtung der Wärmequelle. Ist der Kompensationsabschnitt als Balg ausgebildet, verlaufen die Schlitze senkrecht zu dessen Falten.

Für eine vorzugsweise stoffschlüssige Anbindung des Trägerelementes an die Wärmequelle und die Wärmesenke sind an der Platte Verbindungselemente angeordnet, die sich winklig, insbesondere senkrecht zur Plattenebene erstrecken. Sofern die Verbindungselemente als Laschen ausgeführt sind, können diese durch Abkanten der Platte an gegenüberliegenden Längsseiten hergestellt werden. Zur Anbindung des Trägerelementes an rohrförmige Wärmequellen bzw. Wärmesenken sind die Verbindungselemente vorzugsweise hülsenförmig ausgebildet. Die Größe der Kontaktfläche zwischen der Hülse und dem Rohr führt zu einer sehr guten thermischen Anbindung. Sofern die Hülse die Platte durchsetzt, kann das Rohr der Wärmesenke bzw. Wärmequelle durch die Hülse hindurchgeführt werden. Um eine gleichmäßige Wärmeeinkopplung bzw. Auskopplung zu erreichen, sind mehrere Verbindungselemente gleichmäßig entlang der heißen bzw. kalten Seite des thermoelektrischen Dünnschichtelementes angeordnet. Ist nur ein Verbindungselement an der heißen und ein Verbindungselement an der kalten Seite des thermoelektrischen Dünnsichtelementes angeordnet, entspricht die Längserstreckung des Verbindungselementes in der Plattenebene in etwa der Längserstreckung des thermoelektrischen Dünnschichtelementes entlang der heißen und kalten Seite.

Um die Wärmeleitung zur Wärmequelle bzw. Wärmesenke zu verbessern, kann das Tragelement in Teilbereichen mit einer Funktionsschicht versehen sein, die eine höhere Wärmeleitfähigkeit als das Tragelement aufweist. Das Tragelement besteht beispielsweise aus Edelstahl und die Funktionsschicht aus Kupfer. Die Funktionsschicht wird insbesondere im Bereich der Anbindung zur Wärmequelle bzw. Wärmesenke sowie im Überlappungsbereich zwischen Tragelement und thermoelektrischem Dünnschichtelement aufgebracht. In dem Bereich, in dem sich das thermoelektrisch aktive Material befindet, ist die Funktionsschicht unterbrochen, um Verlustwärmeströme zwischen der kalten und heißen Seite des thermoelektrischen Elementes zu vermeiden, das mit seinem Substrat auf die Funktionsschicht aufgebracht ist. Die Unterbrechung der Funktionsschicht kann als Spalt ausgeführt sein.

Abhängig von der Wärmeleitfähigkeit des Tragelementes kann eine weitere Entkopplung der Wärmequelle von der Wärmesenke dadurch erreicht werden, dass das Tragelement, insbesondere dessen Platte, durch mindestens einen Schlitz geteilt ist, wobei ein erster Teil der Platte auf einer Seite des Schlitzes mit der Wärmequelle und ein zweiter Teil der Platte auf der gegenüberliegenden Seite des Schlitzes mit der Wärmesenke in wärmeleitender Verbindung steht.

Aus Stabilitätsgründen können der erste und zweite Teil der Platte durch mindestens einen, vorzugsweise mehrere den Schlitz überbrückende im Verhältnis zur Längserstreckung des Schlitzes schmale Stege miteinander verbunden sein. Über die im Verhältnis zur Schlitzlänge schmalen Stege fließen nur geringe parasitäre Verlustwärmeströme von der heißen zur kalten Seite. Sofern eine Funktionsschicht auf dem Trägerelement vorgesehen ist, ist diese im Bereich der Stege unterbrochen.

Sofern derartige Stege vorgesehen sind, kann der Steganansatz an dem ersten und/oder zweiten Teil der Platte als Kompensationsabschnitt ausgebildet sein. Um im Steganansatz ein elastisches und/oder flexibles Verhalten zu erzielen, können die Materialstärke und/oder die Materialeigenschaften des Steges im Bereich des Ansatzes gegenüber den übrigen Bereichen des Trägerelementes verändert werden. Das thermoelektrisch aktive Material des Dünnschichtelementes befindet sich ausschließlich in einem Bereich oberhalb des Schlitzes in Bezug auf die Plattenoberfläche, wobei die metallisierten Bereiche des Dünnschichtelementes abwechselnd auf dessen heißer Seite mit dem ersten Teil auf dessen kalter Seite mit dem zweiten Teil der Platte bzw. Funktionsschicht wärmeleitend verbunden sind. Die als Kompensationsabschnitte wirkenden Steganansätze legen auf beiden Seiten des thermoelektrisch aktiven Materials jeweils eine Biegelinie zur Aufnahme der unterschiedlichen Ausdehnungen der Wärmequelle und Wärmesenke fest. Die Biegelinien verlaufen entlang der Übergangsbereiche des thermoelektrisch aktiven Materials zu den metallisierten Kontaktbereichen auf dem flexiblen Substrat. In diesem Übergangsbereich kann das Substrat einer Drehbewegung um die Biegelinie des Trägerelementes folgen, ohne dass thermoelektrisch aktive Material durch Scherkräfte zu belasten. Sofern der Schlitz beispielsweise eine Schlitzbreite von 4 mm und das thermoelektrisch aktive Material in Richtung der Schlitzbreite eine Erstreckung von 2 mm aufweist, entsteht bei zentraler Anordnung des thermoelektrisch aktiven Materials in dem Schlitz ein Übergangsbereich von jeweils 1 mm auf beiden Seiten. In diesem Übergangsbereich verläuft die Biegelinie.

In einer vorteilhaften Ausgestaltung der Erfindung umfasst die Wärmesenke und/oder Wärmequelle mindestens ein Rohr für einen Wärmeträger, an das das Trägerelement angebunden ist. Hierdurch lässt sich beispielsweise die Abwärme aus einem Heizkreislauf in einem oder mehreren thermoelektrischen Dünnschichtelementen nutzen.

Indem sich die Rohre der Wärmequelle bzw. Wärmesenke und die diese aufnehmenden hülsenförmigen Verbindungselemente senkrecht zu der Platte des Trägerelementes erstrecken, verläuft der Wärmestrom in den thermoelektrischen Dünnschichtelementen quer zur Fließrichtung des Wärmeträgers in jedem Rohr. Hierdurch wird ein Temperaturabfall entlang des thermoelektrischen Dünnschichtelementes vermieden, was eine deutliche Leistungssteigerung zur Folge hat. Darüber hinaus erlaubt eine Anordnung der Trägerelemente quer zur Längserstreckung der Wärmequelle und Wärmesenke die einwandfreie Funktion des Kompensationsabschnitts in dem Steganansatz.

Sofern jedes Rohr einer Wärmesenke und/oder Wärmequelle an mehrere Trägerelemente angebunden ist, lässt sich eine Kaskade von thermoelektrischen Dünnschichtelementen zu einem Modul zusammenfassen. Die auf den mehreren Trägerelementen angebrachten Dünnschichtelemente können abhängig vom Temperaturverlauf entlang der Rohre teilweise elektrisch in Serie oder parallel geschaltet werden.

In einer Ausführungsform der Erfindung ist die Platte des Trägerelementes ringförmig und durch einen Schlitz in zwei konzentrische Kreisringe geteilt. Ein derart geformtes Tragelement erlaubt eine Anbindung an eine lang gestreckte, insbesondere rohrförmige Wärmequelle und Wärmesenke, die beide senkrecht zu der ringförmigen Platte verlaufen. Die Verbindungselemente zur Anbindung an die Wärmequelle und Wärmesenke erstrecken sich ebenfalls senkrecht zur Plattenebene.

Nachfolgend wird die Erfindung anhand der Figuren näher erläutert. Es zeigen:

**Figur 1a**  eine schematische Seitenansicht eines ersten Ausführungsbeispiels eines Trägerelementes mit einem flexiblen thermoelektrischen Dünnschichtelement vor und nach einer thermomechanischen Ausdehnung,

**Figur 1b**  eine Vorderansicht des Trägerelementes nach Figur 1a,

**Figur 2**  eine schematische Seitenansicht eines zweiten Ausführungsbeispiels eines erfindungsgemäßen Trägerelementes mit einem thermoelektrischen Dünnsichtelement, das auf einem biegesteifen Substrat angeordnet ist,

**Figur 3a**  eine bevorzugte Ausführungsform eines Kompensationsabschnitts mit einer Noppenstruktur in perspektivischer Ansicht,

**Figur 3b**  Seitenansichten der Noppenstruktur nach Figur 3a,

**Figur 4a**     eine Vorderansicht eines dritten Ausführungsbeispiels eines Trägerelementes angebunden an eine ein Rohrbündel umfassende Wärmequelle und Wärmesenke,

**Figur 4b**     ein mit mehreren Trägerelementen nach Figur 4a aufgebautes Modul in perspektivischer Ansicht,

**Figur 5a**     ein Vorderansicht eines vierten Ausführungsbeispiels eines Trägerelementes mit ovaler Kontur,

**Figur 5b**     eine Vorderansicht eines fünften Ausführungsbeispiels eines Trägerelementes angebunden an eine jeweils ein rechteckiges Rohr umfassende Wärmequelle und Wärmesenke,

**Figur 5c**     eine Vorderansicht eines sechsten Ausführungsbeispiels eines Trägerelementes mit Anbindung an eine zentrale Wärmequelle und zwei Wärmesenken,

**Figur 6a**     ein siebtes Ausführungsbeispiel eines ringförmigen Trägerelementes mit darauf angebrachtem flexiblen thermoelektrischen Dünnschichtelement in Vorderansicht und Seitenansicht,

**Figur 6b**     eine Darstellung entsprechend Figur 6a, jedoch ohne das thermoelektrische Dünnschichtelement,

**Figur 7**     ein weiteres Ausführungsbeispiel eines ringförmigen Trägerelementes mit darauf angeordnetem thermoelektrischen Dünnschichtelement mit biegesteifem Substrat in Seitenansicht,

**Figur 8a**     ein mit mehreren Trägerelementen nach Figuren 6 oder 7 aufgebautes Modul in Seitenansicht sowie

**Figur 8b**     das Modul nach Figur 8 a in perspektivischer Ansicht.

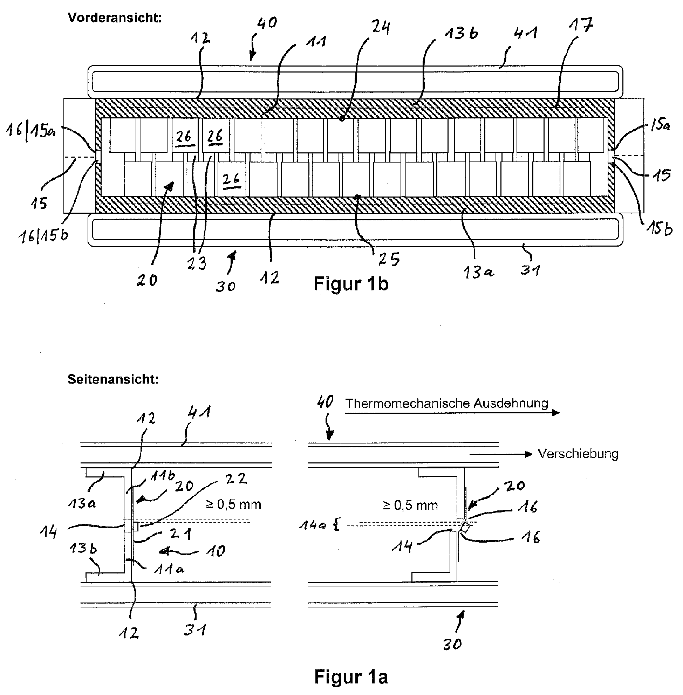

Figur 1a zeigt eine geschnittene Seitenansicht eines erfindungsgemäßen Trägerelementes (10) auf dem ein thermoelektrisches Dünnschichtelement (20) angeordnet ist. Das Trägerelement (10) ist als Blechteil, beispielsweise aus Edelstahlblech ausgeführt und besteht aus einer länglichen rechteckigen Platte (11), die an ihren Längsrändern mit Verbindungselementen (13 a, b) versehen ist, die in dem Ausführungsbeispiel nach Figur 1 als Laschen ausgeführt sind. Die Laschen können abgekantete Abschnitte des Blechteils sein. Das untere Verbindungselement (13a) dient zur Anbindung an eine Wärmesenke (30) und das obere Verbindungselement (13b) zur Anbindung an eine Wärmequelle (40). Die Wärmesenke (30) und die Wärmequelle (40) umfassen jeweils ein Rohr (31, 41) mit einem länglichen, rechteckigen Querschnitt für einen Wärmeträger, der die Rohre (31, 41) quer zur Plattenebene durchströmt.

Wie insbesondere aus Figur 1b erkennbar, erstreckt sich der Rohrquerschnitt über die gesamte Länge des auf dem Trägerelement (10) aufgebrachten, streifenförmigen thermoelektrischen Dünnschichtelementes (20). Das als Lasche ausgeführte obere Verbindungselement (13b) ist stoffschlüssig mit der Unterseite des Rohres (41) und das als Lasche ausgeführte untere Verbindungselement (13a) ist stoffschlüssig an der Oberseite des Rohres (31) angebunden. Die stoffschlüssige Anbindung erfolgt insbesondere durch ein Lot. Die Platte (11) des Trägerelementes (10) wird mittig durch einen parallel zu deren Längsrändern (12) verlaufenden Schlitz (14) in einen ersten und einen zweiten Teil (11a, 11b) geteilt, wobei der erste Teil (11a) der Platte (11) mit der Wärmequelle (40) und der zweite Teile (11b) der Platte auf der gegenüberliegenden Längsseite des Schlitzes (14) mit der Wärmesenke (30) in wärmeleitender Verbindung steht.

An den Seitenrändern der Platte (11) sind der erste Teil (11a) und der zweite Teile (11b) der Platte (11) durch einen den Schlitz (14) überbrückenden Steg (15) miteinander verbunden. Die Stegansätze (15a) an dem ersten Teil (11a) und die Stegansätze (15b) an den zweiten Teil (11b) der Platte (11) definieren zwei Biegelinien als Kompensationsabschnitte (16), die parallel zu den Längsrändern (12) der Platte (11) verlaufen. Die derart gebildeten Kompensationsabschnitte (16) des Trägerelementes (10) gleichen unterschiedliche thermomechanische Ausdehnungen der Wärmequelle (40) und der Wärmesenke (30) aus.

Das thermoelektrische Dünnschichtelement (20) weist in dem Ausführungsbeispiel nach Figur 1a, b ein flexibles, streifenförmiges Substrat (21), beispielsweise in Form einer Polyimid-Folie auf, auf der das thermoelektrisch aktive Material (22) in voneinander getrennten Bereichen (23)aufgebracht ist. Das Aufbringen kann beispielsweise im Wege der Sputterdeposition oder anderen an sich bekannten Verfahren zur Abscheidung von Schichten erfolgen. Die voneinander getrennten Bereiche (23) aus thermoelektrisch aktivem Material (22) sind abwechselnd auf einer heißen Seite (24) und einer kalten Seite (25) des thermoelektrischen Dünnschichtelementes (20) durch metallisierte Bereiche (26) elektrisch leitend miteinander zu einer Reihenschaltung verbunden. Die heiße und kalte Seite (24, 25) des thermoelektrischen Dünnschichtelementes verlaufen parallel zu den Längsrändern (12) der Platte (11) des Trägerelementes (10). Die heiße Seite (24) ist wärmeleitend mit dem Verbindungselement (13b) zur Anbindung an die Wärmequelle (40) und die kalte Seite (25) wärmeleitend mit dem Verbindungselement (13a) an die Wärmesenke (30) verbunden.

Zur Herstellung der wärmeleitenden Verbindung ist das Trägerelement (10) in Teilbereichen mit einer Funktionsschicht (17) (schraffierte Darstellung) versehen, die eine höhere Wärmeleitfähigkeit als das Trägerelement (10) aufweist. Die Funktionsschicht besteht in dem Ausführungsbeispiel aus Kupfer. Die Platte (11) des Trägerelementes (10) ist im Bereich des ersten und zweiten Teils (11a, 11b) der Platte (11) mit der Funktionsschicht (17) versehen. Im Bereich der Stege (15) ist indes keine Funktionsschicht angebracht, um parasitäre Verlustwärmeströme zwischen der heißen und kalten Seite (24, 25) zu reduzieren. Die Funktionsschicht (17) ist darüber hinaus auf den mit den Rohren (31, 41) in Kontakt gelangenden Oberflächen der Verbindungselemente (13a, 13b) aufgebracht, um eine gute thermische Anbindung an die Wärmesenke (30) bzw. Wärmequelle (14) zu erreichen.

Um das flexible Substrat (21) der thermoelektrischen Dünnschichtelementes (20) auf der Funktionsschicht (17) des Trägerelementes zu befestigen, ist das Substrat auf seiner rückwärtigen, der Funktionsschicht (17) zugewandten Seite mit einer Beschichtung, insbesondere Metallisierung versehen, die ein Auflöten des thermoelektrischen Dünnschichtelementes (20) auf dem mit der Funktionsschicht (17) versehenen Trägerelement (10) ermöglicht.

Insbesondere aus der Seitenansicht nach Figur 1a ist erkennbar, dass die getrennten Bereiche (23) mit thermoelektrisch aktivem Material (22) sich zwischen der heißen und kalten Seite (24, 25) nicht über die gesamte Schlitzbreite (14a) erstrecken. Im dargestellten Ausführungsbeispiel beträgt die Schlitzbreite 4 mm, während sich die Bereiche (23) mit dem thermoelektrisch aktiven Material (22) lediglich über eine Länge von 2 mm erstrecken. Das mittig über dem Schlitz (14) angeordnete thermoelektrisch aktive Material (22) gewährleistet, dass sich kein thermoelektrisch wirksames Material im Bereich der durch die Steganätze (15a, 15b) definierten Biegelinien befindet. Entlang dieser Biegelinien befindet sich ausschließlich das flexible Substrat (21), das durch die Biegung nicht beeinträchtigt wird.

Das Trägerelement (10) nach Figur 1 arbeitet wie folgt:

Bei Erwärmung des Rohres (41) der Wärmequelle (40) dehnt sich das Rohr (41) relativ zu dem Rohr (31) der Wärmesenke (30) in erster Linie quer zur Oberfläche der Platte (11) aus, wie dies in der rechten Bildhälfte der Figur 1 a dargestellt ist. Spannungen aufgrund der thermomechanischen Ausdehnung zwischen der Wärmequelle (40) und der Wärmesenke (30) werden in die Stege (15) des Trägerelementes (10) eingeleitet und bewirken in den Steganätzen (15a, 15b) eine Biegebewegung, um die durch die Steganätze (15a, 15b) definierten Biegelinien, die parallel zu den Längsrändern (12) verlaufen. Durch die Biegung um die in der Plattenebene liegenden Biegelinien lassen sich die Ausdehnungen quer zur Plattenebene vollständig in den Kompensationsabschnitten (16) ausgleichen.

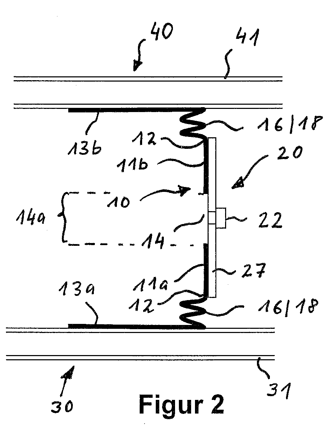

Figur 2 zeigt eine Ausführungsform eines Trägerelementes (10) auf dem ein thermoelektrisches Dünnschichtelement (20) mit einem biegesteifen Substrat (27) angeordnet ist. Das aus Kupferblech bestehende Trägerelement (10) ist insbesondere für Hochtemperaturanwendungen geeignet. Es weist in Übereinstimmung mit der Ausführungsform nach Figur 1 eine durch einen Schlitz (14), allerdings mit deutlich größerer Schlitzbreite (14a), in einen ersten Teil (11a) und einen zweiten Teil (11b) geteilte Platte (11) auf, an der das biegesteife Substrat (27) des thermoelektrischen Dünnschichtelementes (20) wärmeleitend befestigt ist, beispielsweise durch Verlöten. Die Verbindungselemente (13a, 13b) zur Anbindung an die Wärmesenke (30) bzw. Wärmequelle (40) sind ebenfalls als Laschen ausgeführt. Das obere Verbindungselement (13b) ist über einen Kompensationsabschnitt (16) mit dem oberen Längsrand (12) der Platte (11) verbunden. Das untere Verbindungselement (13b) ist über einen Kompensationsabschnitt (16) mit dem unteren Längsrand (12) der Platte (11) verbunden. Die beiden Kompensationsabschnitte (16) überlappen nicht mit dem biegesteifen Substrat (27), sondern erstrecken sich von den Längsrändern (12) der Platte (11) in Richtung der Wärmesenke (30) bzw. der Wärmequelle (40). Die als Laschen ausgeführten Verbindungselemente (13a, 13b) sind in gleicher Weise stoffschlüssig an die Wärmequelle bzw. Wärmesenke (30, 40) angebunden, wie bei de Ausführungsbeispiel nach Figur 1.

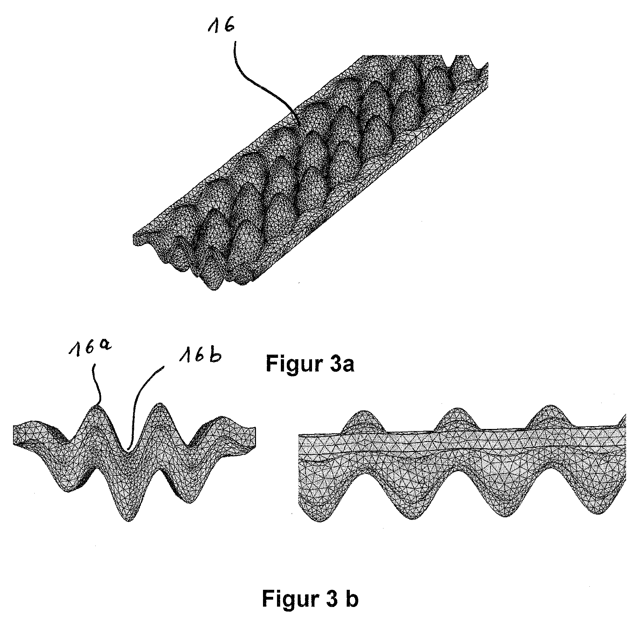

In dem Ausführungsbeispiel nach Figur 2 sind die Kompensationsabschnitte (16) als elastischer Balg (18) ausgestaltet, der sich über die gesamte Länge des Trägerelementes (10) erstreckt. Alternativ kann der Kompensationsabschnitt (16) eine zweidimensionale Abfolge von Erhebungen (16a) und Vertiefungen (16b) aufweisen, wie dies in Figur 3a erkennbar ist. Eine derart gebildete Noppenstruktur lässt Ausgleichsbewegungen in allen Raumrichtungen zu.

Das Trägerelement (10) nach Figur 2 arbeitet wie folgt:

Bei Erwärmung des Rohres (41) der Wärmequelle (40) dehnt sich das Rohr (41) relativ zu dem Rohr (31) der Wärmesenke (30) in erster Linie quer zur Oberfläche der Platte (11) aus. Spannungen aufgrund der thermomechanischen Ausdehnung zwischen der Wärmequelle (40) und der Wärmesenke (30) werden in die elastischer Balge (18) des Trägerelementes (10) eingeleitet und bewirken durch deren Verformung den Ausgleich der unterschiedlichen Ausdehnungen von Wärmequelle (40) und Wärmesenke (30). Das auf der Platte (11) angeordnete thermoelektrische Dünnschichtelement (20) wird nicht belastet.

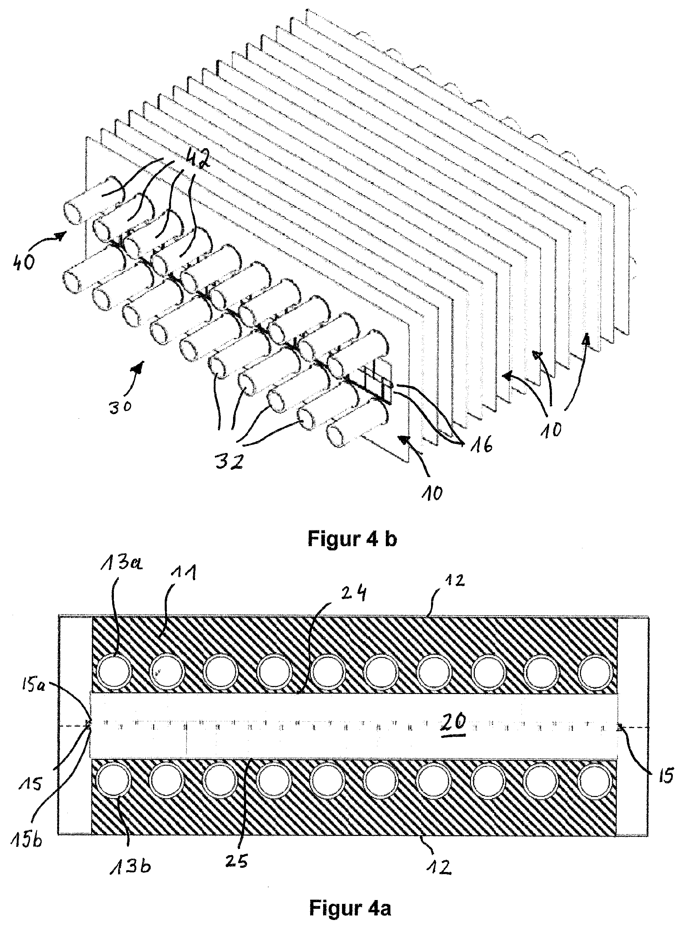

Das Trägerelement (10) nach Figur 4a stimmt im Aufbau mit dem Trägerelement (10) nach Figur 1a, b weitgehend überein, so dass zur Vermeidung von Wiederholungen auf die dortigen Ausführungen vollinhaltlich Bezug genommen wird. Unterschiede ergeben sich hinsichtlich des Aufbaus der Wärmesenke und der Wärmequelle (30, 40) sowie der Anbindung des Trägerelementes an die Wärmequelle und Wärmesenke (30, 40). Die Wärmesenke (30) und die Wärmequelle (40) umfassen jeweils ein Rohrbündel (32, 42). Die Rohre eines Rohrbündels (32, 42) verlaufen parallel und im Abstand zueinander, wobei sich jedes Rohr der Rohrbündel (32, 42) senkrecht zur Plattenebene des Trägerelementes (10) erstreckt. An der Platte (11) des Trägerelementes (10) sind auf der heißen und kalten Seite (24, 25) des thermoelektrischen Dünnschichtelementes (20) entsprechend der Anzahl der Rohre der Rohrbündel (32, 42) als Hülsen ausgebildete Verbindungselemente (13a, 13b) angeordnet. Der Außenmantel jedes Rohres ist vorzugsweise stoffschlüssig, beispielsweise mittels einer Lötverbindung mit einer der Hülsen verbunden. Die großflächige Anbindung des Trägerelementes (10) über die Hülsen an die Rohre der Wärmesenke bzw. Wärmequelle (30, 40) erhöht die Wärmestromdichte und steigert die Effizienz des mit dem Trägerelement (10) in wärmeleitender Verbindung stehenden thermoelektrischen Dünnschichtelementes (20).

Das Trägerelement (10) nach Figur 4 a arbeitet wie folgt:

Bei Erwärmung der Rohre des Rohrbündels (42) dehnt sich die Wärmequelle (40) relativ zu den Rohren des Rohrbündels (32) der Wärmesenke (30) in erster Linie quer zur Oberfläche der Platte (11) aus. Spannungen aufgrund der unterschiedlichen Ausdehnungen zwischen der Wärmequelle (40) und der Wärmesenke (30) werden in die Stege (15) des Trägerelementes (10) eingeleitet und bewirken in den Stegansätzen (15a, 15b) eine Biegebewegung, um die durch die Stegansätze (15a, 15b) definierten Biegelinien, die parallel zu den Längsrändern (12) der Platte (11) verlaufen. Durch die Biegung um die in der Plattenebene liegenden Biegelinien lassen sich die Ausdehnungen quer zur Plattenebene vollständig in den Kompensationsabschnitten (16) ausgleichen.

Figur 4b zeigt ein Modul (50), das mehrere baugleiche Trägerelemente (10) nach Figur 4a umfasst, wobei sämtliche Trägerelemente (10) in gleicher Weise, nach Art eines Stapels, an die Rohrbündel (32, 42) der Wärmesenke (30) bzw. Wärmequelle (40) angebunden sind. Jedes Rohr der beiden Rohrbündel (32, 42) verläuft senkrecht zur Plattenebene der Trägerelemente (20).

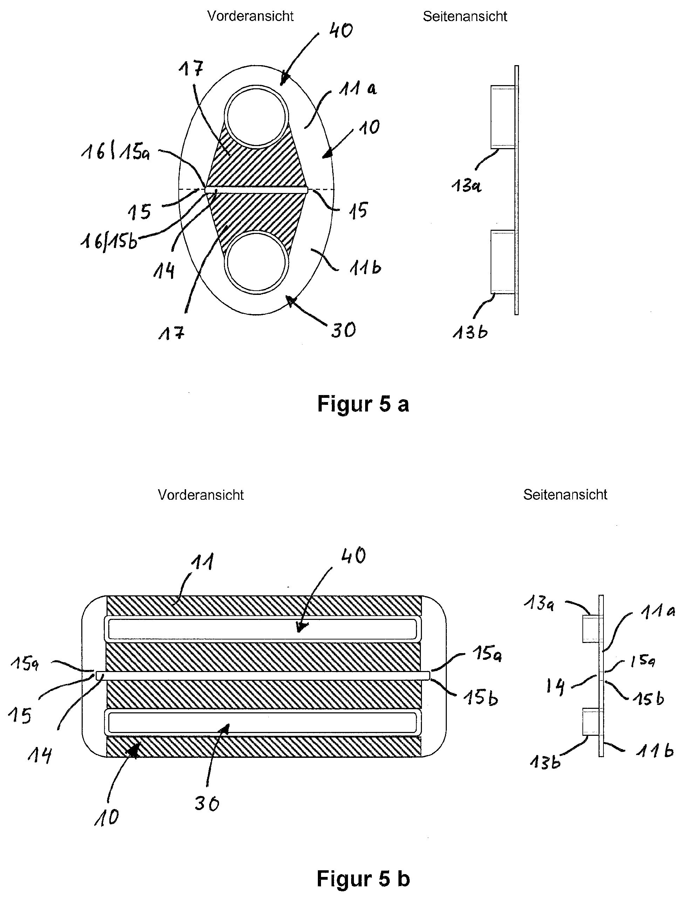

Bei dem Ausführungsbeispiel des Trägerelementes nach Figur 5a umfasst die Wärmesenke (30) bzw. Wärmequelle (40) jeweils nur ein einziges im Querschnitt kreisförmiges Rohr (31, 41). Die Kontur des Trägerelementes (10) ist abweichend zu den vorangegangenen Ausführungsbeispielen nicht rechteckig, sondern oval. Die Verbindungselemente (13a, 13b) sind entsprechend dem Ausführungsbeispiel nach Figur 4a als Hülsen ausgeführt. Die ovale Platte ist ebenfalls durch einen horizontal verlaufenden Schlitz (14) geteilt. Der erste Teil (11a) und der zweite Teile (11b) der Platte sind durch die beiden äußeren, den Schlitz überbrückenden Stege (15) miteinander verbunden. Übereinstimmend mit den übrigen Ausführungsbeispielen bilden die Stegansätze (15a, 15b) an dem ersten und zweiten Teil (11a, 11b) der Platte (11) den elastischen Kompensationsabschnitt (16) des Trägerelementes. Auf der Vorderansicht auf das Trägerelement (10) ist erkennbar, dass die gut wärmeleitende Funktionsschicht (17) nicht im Bereich der Stege (15) sowie im Bereich des Schlitzes (14) vorgesehen ist. An den Innenfläche der Hülsen ist die Funktionsschicht jedoch aufgebracht, um die thermische Anbindung an die Oberfläche der Wärmequelle bzw. Wärmesenke (30, 40) zu verbessern. Auch bei dieser Ausführungsform können mehrere übereinstimmende baugleiche Trägerelemente (10) in einer Art Stapel hintereinander auf dem Rohr der Wärmesenke (30) bzw. dem Rohr der Wärmequelle (40) angeordnet sein.

Die Ausführungsform des Trägerelementes (10) nach Figur 5b entspricht der Ausführungsform des Trägerelementes nach Figur 4a mit dem Unterschied, dass die Wärmequelle und die Wärmesenke (30, 40) nicht als Rohrbündel (32, 42) ausgebildet ist, sondern als ein im Querschnitt rechteckiges Rohr (31, 41), das sich über die volle Breite des in Figur 5b nicht dargestellten thermoelektrischen Dünnschichtelementes (20) mit flexiblem Substrat (21) erstreckt. Die Funktionsweise des Kompensationsabschnitts (16) entspricht derjenigen nach den Ausführungsbeispielen gemäß der Figuren 1, 4 und 5, so dass zur Vermeidung von Wiederholungen auf die dortigen Ausführungen Bezug genommen wird.

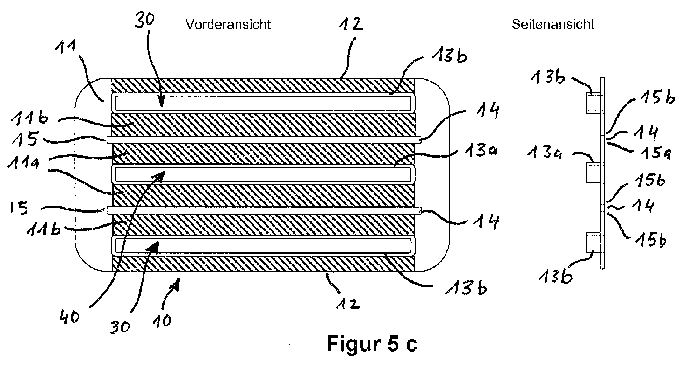

Das Trägerelement (10) nach Figur 5c ist für die Anordnung von zwei streifenförmigen, in Figur 5c nicht dargestellten flexiblen thermoelektrischen Dünnschichtelementen (20) geeignet. Mittig erstreckt sich über die Länge des Trägerelementes (10) ein als lang gestreckte rechteckige Hülse ausgebildetes Verbindungselement (13a) für die Anbindung an die Wärmequelle (40) durch ein zentrales, im Querschnitt rechteckiges Rohr (41).

Im Bereich der Längsränder (12) des Trägerelementes erstrecken sich in gleicher Richtung wie das Verbindungselement (13a) zwei als lang gestreckte rechteckige Hülsen ausgebildete Verbindungselemente (13b) zur Anbindung des Trägerelementes an jeweils ein im Querschnitt rechteckiges Rohr (31) einer Wärmsenke (30). Zwischen dem Verbindungselement (13a) und den beiden Verbindungselementen (13b) ist die Platte (11) des Trägerelementes jeweils durch einen Schlitz (14) geteilt, wobei jeweils ein erster Teil (11a) der Platte (11) auf einer Längsseite des Schlitzes (14) mit der Wärmequelle (40) und jeweils ein zweiter Teil (11b) der Platte (11) auf der gegenüberliegenden Seite jedes Schlitzes (14) mit einem der beiden Rohre (31) der Wärmesenke (30) in wärmeleitender Verbindung steht. Zu beiden Seiten der beiden Schlitze (14) befinden sich Verbindungsstege (15), deren Stegansätze (15a, 15b) die Kompensationsabschnitte (16) des Trägerelementes zwischen der Anbindung an die Wärmequelle (40) und der Anbindung an die Wärmesenken (30) darstellen.

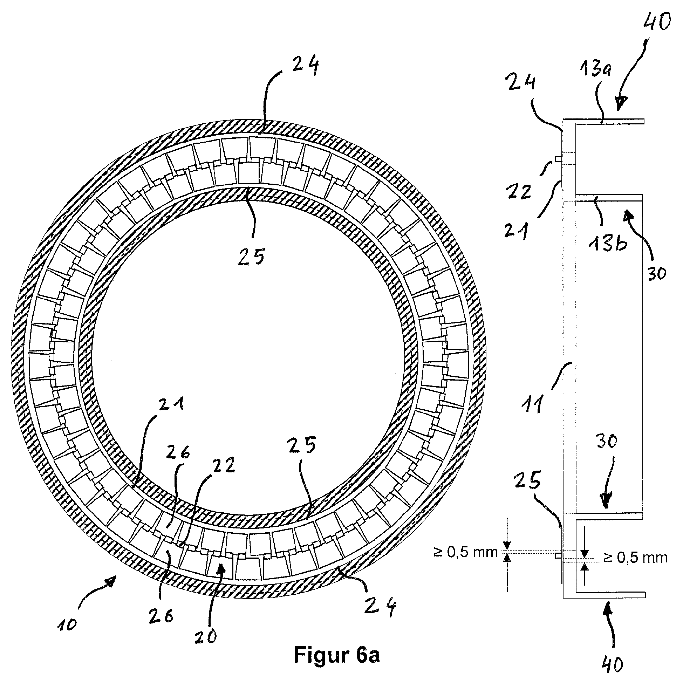

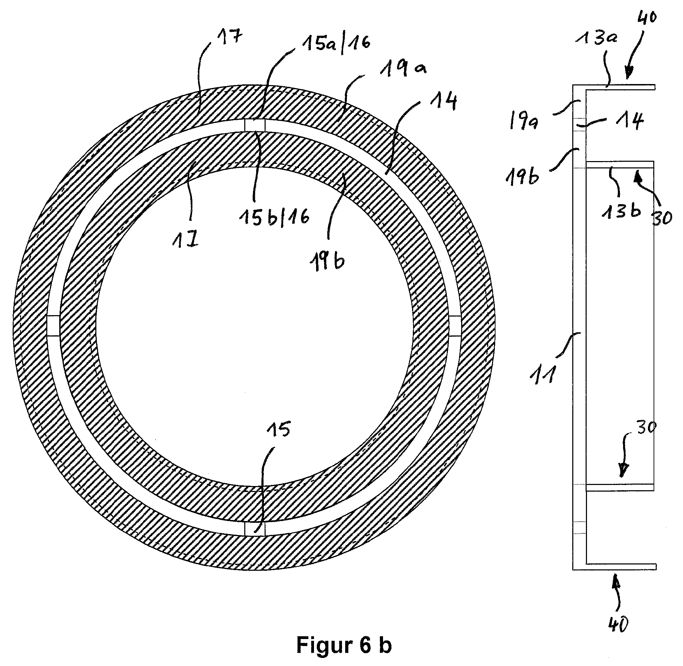

Die Figuren 6a, 6b zeigen ein Ausführungsbeispiel eines Trägerelementes (10) mit einer ringförmigen Platte (11) auf der ringförmig ein flexibles thermoelektrisches Dünnschichtelement (20) angeordnet ist. Wie insbesondere aus Figur 6b erkennbar, ist die ringförmige Platte (11) durch einen kreisförmigen Schlitz (14) in zwei konzentrische Kreisringe (19a, 19b) geteilt. Die Kreisringe (19a, 19b) sind an vier um 90 Grad versetzt zueinander angeordneten Stellen den Schlitz (14) überbrückend durch Stege (15) miteinander verbunden. Am äußeren Umfang der ringförmigen Platte (11) ist ein über den gesamten Umfang umlaufendes Verbindungselement (13a) zur Anbindung an eine Wärmequelle (40) angeordnet. Am inneren Umfang der ringförmigen Platte ist ein über den gesamten Umfang umlaufendes Verbindungselement (13b) für die Anbindung an eine Wärmesenke (30) angeordnet. Die als Laschen ausgebildete Verbindungselemente (13a, 13b) verlaufen rechtwinklig zur Plattenoberfläche. In den Stegansätzen (15a, 15b) der Verbindungsstege liegen die Kompensationsabschnitte (16) des Trägerelementes (10). Die Funktionsschicht (17) aus gut wärmeleitendem Material ist auf der nach außen weisenden ringförmigen Oberfläche der Kreisringe (19a, 19b), die mit dem thermoelektrischen Dünnschichtelement in Berührung kommt, angebracht. Um parasitäre Wärmeströme von der heißen zur kalten Seite (24, 25) zu vermeiden, sind die Oberflächen der Stege (15) nicht mit der Funktionsschicht (17) versehen. Darüber hinaus befindet sich die Funktionsschicht (17) auf den Oberflächenbereichen der Verbindungselemente (13a, 13b), die der Anbindung an die Wärmequelle (40) und der Wärmesenke (30) dienen.

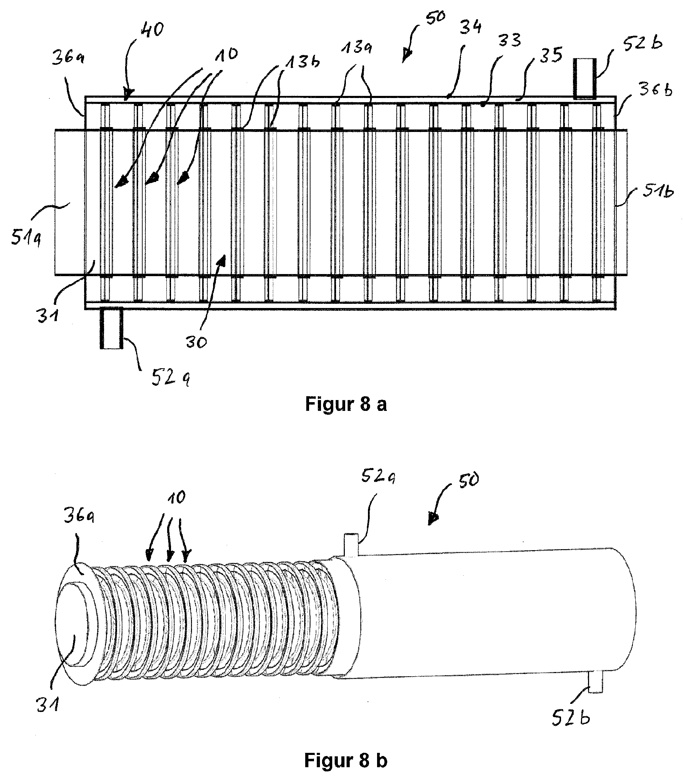

Das ringförmige Trägerelement (10) ermöglicht eine koaxiale Anordnung von Wärmequelle (40) und Wärmesenke (30), wie sie nachfolgend anhand der Figur 8 erläutert wird. Unterschiedliche Ausdehnungen zwischen der Wärmequelle (40) und der Wärmesenke (30) parallel zur Erstreckung der Verbindungselemente (13a, 13b) werden in den Stegansätzen (15a, 15b) der Stege (15) durch Biegung ausgeglichen. Die Anordnung der thermoelektrisch aktiven Materialien (22) des flexiblen thermoelektrischen Dünnschichtelementes (20) in Bezug zu dem Schlitz (14) entspricht der Anordnung nach Figuren 1, 4 und 5.

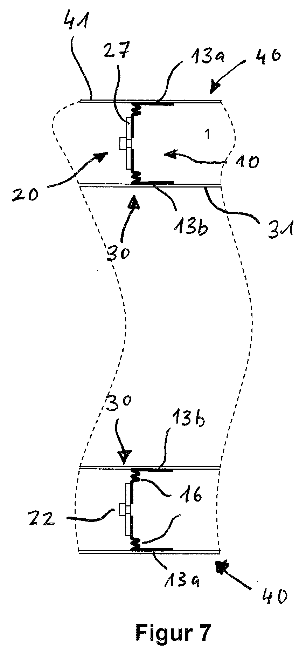

Das Ausführungsbeispiel nach Figur 7 unterscheidet sich von dem ringförmigen Trägerelement (10) nach Figur 6a, b dadurch, dass das auf dem Trägerelement (10) aufgebrachte thermoelektrische Dünnschichtelement (20) ein biegesteifes Substrat (27) aufweist. Die Anordnung der Kompensationsabschnitte (16) sowie der Verbindungselemente (13a, 13b) entspricht dem Aufbau nach Figur 2, so dass auf die dortigen Ausführungen vollumfänglich Bezug genommen wird. Die Verbindungsabschnitte (13a, 13b) des Trägerelementes (10) sind mit koaxial zueinander angeordneten Rohren einer Wärmesenke (30) und Wärmequelle (40) verbunden. Das Trägerelement (10) besteht insbesondere aus einem Kupferblech. Die Verbindungselemente (13 a, b) werden durch Verlöten, Kleben oder Schweißen stoffschlüssig an die Rohre (31, 41) von Wärmesenke und Wärmequelle (30, 40) angebunden. Das Trägerelement nach Figur 7 eignet sich insbesondere für Anwendungen im Temperaturbereich oberhalb von 250 Grad Celsius, da das biegesteife Substrat (27) ebenfalls aus hochtemperatur-beständigem Material bestehen kann.

Figur 8 zeigt ein Modul (50) umfassend mehrere baugleiche Trägerelemente (10) in einer Ausführungsform nach Figur 6 oder 7. Die Trägerelemente (10) werden hintereinander in gleichmäßigem Abstand auf einem Rohr (31) der Wärmesenke (30) angeordnet und mit Hilfe der Verbindungselemente (13b) stoffschlüssig mit der Mantelfläche des Rohres (31) verbunden. Die am äußeren Umfang der kreisringförmigen Trägerelemente angeordneten Verbindungselemente (13a) sind an ein inneres Mantelrohr (33) der Wärmequelle (40) angeordnet. Die Wärmequelle (40) umfasst weiter ein äußeres Mantelrohr (34), das unter Ausbildung eines Ringraums (35) das innere Mantelrohr (33) umgibt. Stirnseitig verschließen Abschlussbleche (36a, 36b) den Ringraum (35). Im Bereich der beiden Stirnseiten (51a, 51b) des Moduls (50) sind am äußeren Mantelrohr (34) der Wärmequelle (40) Anschlussstutzen (52a, 52b) angeordnet. Ein Wärmeträger wird über den Anschlussstutzen (52a) in den Ringraum (35) geleitet und verlässt den Ringraum über den Anschlussstutzen (52b).

## Bezugszeichenliste

| Nr. | Bezeichnung | Nr. | Bezeichnung |
|---|---|---|---|
| 10 | Trägerelement | 30 | Wärmesenke |
| 11 | Platte | 31 | Rohr |
| 11 a | erster Teil | 32 | Rohrbündel |
| 11 b | zweiter Teil | 33 | Mantelrohr inneres |
| 12 | Längsränder | 34 | Mantelrohr äußeres |
| 13 a, b | Verbindungselement | 35 | Ringraum |
| 14 | Schlitz | 36 a, b | Abschlussbleche |
| 14 a | Schlitzbreite | | |
| 15 | Steg | | |
| 15 a | Stegansatz | | |
| 15 b | Stegansatz | 40 | Wärmequelle |
| 16 | Kompensationsabschnitt | 41 | Rohr |
| 16 a | Erhebungen | 42 | Rohrbündel |
| 16 b | Vertiefungen | | |

(fortgesetzt)

| Nr. | Bezeichnung | Nr. | Bezeichnung |
|---|---|---|---|
| 17 | Funktionsschicht | | |
| 18 | elastischer Balg | | |
| 19 a, b | Kreisringe | 50 | Modul |
| | | 51 a, b | Stirnseiten |
| | | 52 a, b | Anschlussstutzen |
| | | | |
| 20 | thermoelektrisches Dünnschichtelement | | |
| 21 | flexibles Substrat | | |
| 22 | thermoelektrisch aktives Material | | |
| 23 | getrennte Bereiche | | |
| 24 | heiße Seite | | |
| 25 | kalte Seite | | |
| 26 | metallisierte Bereiche | | |
| 27 | biegesteifes Substrat | | |

**Patentansprüche**

1. Trägerelement (10) umfassend eine Anbindung an eine Wärmequelle (40) und eine Anbindung an eine Wärmesenke (30) sowie ein auf dem Trägerelement (10) zwischen der Anbindung an die Wärmequelle (40) und der Anbindung an die Wärmesenke (30) angeordnetes thermoelektrisches Dünnschichtelement (20) mit einer heißen und einer kalten Seite (24, 25), wobei die heiße Seite (24) wärmeleitend mit der Anbindung an die Wärmequelle (40) und die kalte Seite (25) wärmeleitend mit der Anbindung an die Wärmesenke (30) verbunden sind, **dadurch gekennzeichnet, dass**

   - das Trägerelement (10) eine Platte (11) zum Aufbringen des thermoelektrischen Dünnschichtelements (20) und an der Platte (10) angeordnete Verbindungselemente (13a, b) für die Anbindung des Trägerelementes (10) an die Wärmequelle (40) und die Wärmesenke (30) aufweist sowie
   - mindestens ein elastischer und/oder flexibler Kompensationsabschnitt (16) des Trägerelementes (10) zwischen der Anbindung an die Wärmequelle (40) und der Anbindung an die Wärmesenke (30) derart eingerichtet ist, dass er unterschiedliche Ausdehnungen der Wärmequelle und der Wärmesenke durch eine Formänderung des Kompensationsabschnitts (16) ausgleicht.

2. Trägerelement nach Anspruch 1, **dadurch gekennzeichnet, dass** der Kompensationsabschnitt (16) ein linear-elastisches Verhalten aufweist.

3. Trägerelement nach Anspruch 1 oder 2, **dadurch gekennzeichnet, dass** der Kompensationsabschnitt (16) Erhebungen (16a) und/oder Vertiefungen (16b) aufweist.

4. Trägerelement nach einem der Ansprüche 1 oder 2, **dadurch gekennzeichnet, dass** der Kompensationsabschnitt (16) eine Noppenstruktur aufweist.

5. Trägerelement nach Anspruch 1 oder 2, **dadurch gekennzeichnet, dass** der Kompensationsabschnitt (16) als ein elastischer Balg (18) ausgestaltet ist.

6. Trägerelement nach Anspruch 1 oder 2, **dadurch gekennzeichnet, dass** der Kompensationsabschnitt (16) aus einem Weichstoff besteht.

7. Trägerelement nach einem der Ansprüche 1 bis 6, **dadurch gekennzeichnet, dass** das thermoelektrische Dünnschichtelement (20) ein Substrat (21, 27) und ein auf dem Substrat (21, 27) aufgebrachtes thermoelektrisch aktives Material (22) aufweist.

8. Trägerelement nach Anspruch 7, **dadurch gekennzeichnet, dass** voneinander getrennte Bereiche (23) aus dem thermoelektrisch aktivem Material (22) abwechselnd auf der heißen und der kalten Seite (24, 25) des Dünnschichtelementes (20) durch metallisierte Bereiche (26) elektrisch leitend miteinander verbunden sind.

9. Trägerelement nach Anspruch 7 oder 8, **dadurch gekennzeichnet, dass** das Substrat (21) aus einem flexiblen Material besteht.

10. Trägerelement nach Anspruch 7 oder 8, **dadurch gekennzeichnet, dass** das Substrat (27) aus einem biegesteifen Material besteht.

11. Trägerelement nach einem der Ansprüche 1 bis 10, **dadurch gekennzeichnet, dass** das Substrat (21, 27) derart auf der Oberfläche des Trägerelementes (10) angeordnet ist, dass sich kein thermoelektrisch wirksames Material (22) in einem Bereich oberhalb einer Oberfläche eines Kompensationsabschnitts (16) des Trägerelementes (10) befindet.

12. Trägerelement nach einem der Ansprüche 1 bis 11, **dadurch gekennzeichnet, dass** die Anbindung an die Wärmequelle (40) und die Anbindung an die Wärmesenke (30) stoffschlüssig sind.

13. Trägerelement nach Anspruch einem der Ansprüche 1 bis 12, **dadurch gekennzeichnet, dass** die Verbindungselemente (13a, b) als Hülsen ausgebildet sind und sich senkrecht zur Plattenebene erstrecken.

14. Trägerelement nach einem der Ansprüche 1 bis 12, **dadurch gekennzeichnet, dass** die Verbindungselemente (13a, b) als Laschen ausgebildet sind, die sich insbesondere senkrecht zur Plattenebene erstrecken.

15. Trägerelement nach einem der Ansprüche 1 bis 14, **dadurch gekennzeichnet, dass** es in Teilbereichen mit einer Funktionsschicht (17) versehen ist, die eine höhere Wärmeleitfähigkeit als der Werkstoff des Trägerelements (10) aufweist.

16. Trägerelement nach einem der Ansprüche 1 bis 15, **dadurch gekennzeichnet, dass** die Platte (11) durch mindestens einen Schlitz (14) geteilt ist, wobei ein erster Teil (11a) der Platte auf einer Längsseite des Schlitzes (14) mit der Wärmequelle (40) und ein zweiter Teil (11b) der Platte (11) auf der gegenüberliegenden Längsseite des Schlitzes (14) mit der Wärmesenke (30) in wärmeleitender Verbindung steht.

17. Trägerelement nach Anspruch 16, **dadurch gekennzeichnet, dass** der erste und zweite Teil (11a, b) der Platte (11) durch mindestens einen den Schlitz (14) überbrückenden Steg (15) miteinander verbunden sind.

18. Trägerelement nach Anspruch 17, **dadurch gekennzeichnet, dass** jeder Stegansatz (15a, 15b) an dem ersten und/oder zweiten Teil (11a, b) der Platte (11) als elastischer Kompensationsabschnitt (16) ausgebildet ist.

19. Trägerelement nach Anspruch 18, **dadurch gekennzeichnet, dass** das thermoelektrisch aktive Material (22) des Dünnschichtelements (20) sich ausschließlich in einem Bereich oberhalb des Schlitzes (14) in Bezug auf die Plattenoberfläche befindet.

20. Trägerelement nach einem der Ansprüche 15 bis 19, **dadurch gekennzeichnet, dass** die Platte (11) ringförmig ist und durch den Schlitz (14) in zwei konzentrische Kreisringe (19a, b) geteilt ist.

21. Trägerelement nach einem der Ansprüche 1 bis 19, **dadurch gekennzeichnet, dass** die Platte (11) rechteckig ist.

22. Trägerelement nach einem der Ansprüche 1 bis 21, **dadurch gekennzeichnet, dass** die Wärmesenke (30) und/oder Wärmequelle (40) mindestens ein Rohr (31,41) für einen Wärmeträger umfasst, an das das Trägerelement (10) angebunden ist.

23. Trägerelement nach Anspruch 22, **dadurch gekennzeichnet, dass** sich jedes Rohr (31,41) senkrecht zur Plattenebene des Trägerelements (10) erstreckt.

24. Modul (50) umfassend mehrerer baugleiche Trägerelemente (10) nach einem oder mehreren der Ansprüche 1 bis 23 und eine gemeinsame Wärmequelle (40) und/oder Wärmesenke (30) an die sämtliche Trägerelemente (10) angebunden sind.

25. Modul (50) nach Anspruch 24, **dadurch gekennzeichnet, dass** die Wärmesenke (30) und/oder Wärmequelle (40) mindestens ein Rohr (31, 41) für die Durchleitung eines Wärmeträgers umfasst, an das sämtliche Trägerelement angebunden sind.

26. Modul nach Anspruch 25, **dadurch gekennzeichnet, dass** jedes Rohr (31, 41) quer zu der Oberfläche jedes Trägerelements (10) verläuft.

**Claims**

1. A carrier element (10), comprising a connection to a heat source (40) and a connection to a heat sink (30) as well as a thermoelectric thin-film element (20) having a hot side and a cold side (24, 25) arranged on the carrier element (10) between the connection to the heat source (40) and the connection to the heat sink (30), wherein the hot side (24) is connected in a heat-conducting manner to the connection to the heat source (40), and the cold side (25) is connected in a heat-conducting manner to the connection to the heat sink (30), **characterized in that**

   - the carrier element (10) comprises a plate (11) for application of the thermoelectric thin-film element (20) and has connecting elements (13a, b) disposed on the plate (10) for connection of the carrier element (10) to the heat source (40) and the heat sink (30) and
   - at least one elastic and/or flexible compensating section (16) of the carrier element (10) between the connection to the heat source (40) and the connection to the heat sink (30) is adapted in such a manner that said compensating section compensates for different expansions of the heat source and the heat sink by a change of shape of the compensating section (16).

2. The carrier element according to claim 1, **characterized in that** the compensating section (16) exhibits linear-elastic behaviour.

3. The carrier element according to claim 1 or 2, **characterized in that** the compensating section (16) comprises elevations (16a) and/or depressions (16b).

4. The carrier element according to any one of claims 1 or 2, **characterized in that** the compensating section (16) comprises a nubby structure.

5. The carrier element according to claim 1 or 2, **characterized in that** the compensating section (16) is configured as an elastic bellows (18).

6. The carrier element according to claim 1 or 2, **characterized in that** the compensating section (16) consists of a soft material.

7. The carrier element according to any one of claims 1 to 6, **characterized in that** the thermoelectric thin-film element (20) comprises a substrate (21, 27) and a thermoelectrically active material (22) applied to the substrate (21, 27).

8. The carrier element according to claim 7, **characterized in that** areas (23) of the thermoelectrically active material (22), which are separated from each other are connected to one another in an electrically conducting manner by metalized areas (26) alternately on the hot and cold side (24, 25) of the thin-film element (20).

9. The carrier element according to claim 7 or 8, **characterized in that** the substrate (21) consists of a flexible material.

10. The carrier element according to claim 7 or 8, **characterized in that** the substrate (27) consists of a rigid material.

11. The carrier element according to any one of claims 1 to 10, **characterized in that** the substrate (21, 27) is arranged on the surface of the carrier element (10) in such a manner that no thermoelectrically active material (22) is located in an area above a surface of a compensating section (16) of the carrier element (10).

**12.** The carrier element according to any one of claims 1 to 11, **characterized in that** the connection to the heat source (40) and the connection to the heat sink (30) are permanently bonded connections.

**13.** The carrier element according to any one of claims 1 to 12, **characterized in that** the connecting elements (13a, b) are configured as sleeves and extend perpendicular to the plane of the plate.

**14.** The carrier element according to any one of claims 1 to 12, **characterized in that** the connecting elements (13a, b) are configured as tabs, which extend in particular perpendicular to the plane of the plate.

**15.** The carrier element according to any one of claims 1 to 14, **characterized in that** in subregions it is provided with a functional layer (17), which has higher thermal conductivity than the material of the carrier element (10).

**16.** The carrier element according to any one of claims 1 to 15, **characterized in that** the plate (11) is divided by at least one slot (14), wherein a first part (11a) of the plate on one longitudinal side of the slot (14) is in heat-conducting communication with the heat source (40), and a second part (11b) of the plate (11) on the opposite longitudinal side of the slot (14) is in heat-conducting communication with the heat sink (30).

**17.** The carrier element according to claim 16, **characterized in that** the first and second parts (11a, b) of the plate (11) are connected to each other by at least one web (15) which bridges the slot (14).

**18.** The carrier element according to claim 17, **characterized in that** each web shoulder (15a, 15b) on the first and/or second part (11a, b) of the plate (11) is configured as an elastic compensating section (16).

**19.** The carrier element according to claim 18, **characterized in that** the thermoelectrically active material (22) of the thin-film element (20) is located exclusively in an area above the slot (14) relative to the surface of the plate.

**20.** The carrier element according to any one of claims 15 to 19, **characterized in that** the plate (11) is ringshaped and is divided by the slot (14) into two concentric circular rings (19a, b).

**21.** The carrier element according to any one of claims 1 to 19, **characterized in that** the plate (11) is rectangular.

**22.** The carrier element according to any one of claims 1 to 21, **characterized in that** the heat sink (30) and/or the heat source (40) comprises at least one tube (31, 41) for a heat transfer medium, to which the carrier element (10) is connected.

**23.** The carrier element according to claim 22, **characterized in that** each tube (31, 41) extends perpendicular to the plane of the plate of the carrier element (10).

**24.** A module (50) comprising a plurality of identically configured carrier elements (10) according to one or more of claims 1 to 23 and a common heat source (40) and/or heat sink (30) to which all the carrier elements (10) are connected.

**25.** The module (50) according to claim 24, **characterized in that** the heat sink (30) and/or the heat source (40) comprises at least one tube (31, 41) for the passage of a heat transfer medium to which all the carrier elements are connected.

**26.** The module according to claim 25, **characterized in that** each tube (31, 41) extends transversely to the surface of each carrier element (10).

**Revendications**

**1.** Élément porteur (10) comprenant une liaison sur une source de chaleur (40) et une liaison sur un dissipateur thermique (30), ainsi qu'un élément thermoélectrique (20) en couche mince placé sur l'élément porteur (10), entre la liaison sur la source de chaleur (40) et la liaison sur le dissipateur de chaleur (30), avec un côté chaud et un côté froid (24, 25), le côté chaud (24) étant relié de manière conductrice de chaleur avec la liaison sur la source de chaleur (40) et le côté froid (25) étant relié de manière conductrice de chaleur avec la liaison sur le dissipateur thermique (30), **caractérisé en ce que**

- l'élément porteur (10) comporte une plaque (11) pour l'application de l'élément thermoélectrique (20) en couche mince et des éléments de liaison (13a, b) placés sur la plaque (10), pour la liaison de l'élément porteur (10) sur la source de chaleur (40) et sur le dissipateur thermique (30), ainsi
- qu'en ce qu'entre la liaison sur la source de chaleur (40) et la liaison sur le dissipateur thermique (30), au moins une section compensatrice (16) élastique et/ou souple de l'élément porteur (10) est aménagée de sorte à compenser des dilatations différentes de la source de chaleur et du dissipateur thermique par une variation de forme de la section compensatrice (16).

**2.** Élément porteur selon la revendication 1, **caractérisé en ce que** la section compensatrice (16) fait preuve d'un comportement élastique linéaire.

**3.** Élément porteur selon la revendication 1 ou la revendication 2, **caractérisé en ce que** la section compensatrice (16a) comporte des élévations (16a) et/ou des creux (16b).

**4.** Élément porteur selon la revendication 1 ou la revendication 2, **caractérisé en ce que** la section compensatrice (16) comporte une structure en noppes.

**5.** Élément porteur selon la revendication 1 ou la revendication 2, **caractérisé en ce que** la section compensatrice (16) est conçue en tant que soufflet (18) élastique.

**6.** Élément porteur selon la revendication 1 ou la revendication 2, **caractérisé en ce que** la section compensatrice (16) est constituée d'une matière souple.

**7.** Élément porteur selon l'une quelconque des revendications 1 à 6, **caractérisé en ce que** l'élément thermoélectrique (20) en couche mince comporte un substrat (21, 27) et une matière thermoélectrique active (22) appliquée sur le substrat (21, 27).

**8.** Élément porteur selon la revendication 7, **caractérisé en ce que** des régions (23) séparées l'une de l'autre dans la matière thermoélectrique active (22) sont reliées les unes aux autres de manière conductrice d'électricité par des régions métallisées (26), en alternance sur le côté chaud et le côté froid (24, 25) de l'élément en couche mince (20).

**9.** Élément porteur selon la revendication 7 ou la revendication 8, **caractérisé en ce que** le substrat (21) est constitué d'une matière flexible.

**10.** Élément porteur selon la revendication 7 ou la revendication 8, **caractérisé en ce que** le substrat (27) est constitué d'une matière résistant à la flexion.

**11.** Élément porteur selon l'une quelconque des revendications 1 à 10, **caractérisé en ce que** le substrat (21, 27) est placé sur la surface de l'élément porteur (10) de telle sorte qu'aucune matière thermoélectrique active (22) ne se trouve dans une région au-dessus d'une surface d'une section compensatrice (16) de l'élément porteur (10).

**12.** Élément porteur selon l'une quelconque des revendications 1 à 11, **caractérisé en ce que** la liaison sur la source de chaleur (40) et la liaison sur le dissipateur thermique (30) sont des liaisons par matière.

**13.** Élément porteur selon l'une quelconque des revendications 1 à 12, **caractérisé en ce que** les éléments de liaison (13a, b) sont conçus en tant que douilles et s'étendent à la perpendiculaire du plan de la plaque.

**14.** Élément porteur selon l'une quelconque des revendications 1 à 12, **caractérisé en ce que** les éléments de liaison (13a, b) sont conçus en tant que pattes, qui s'étendent notamment à la perpendiculaire du niveau de la plaque.

**15.** Élément porteur selon l'une quelconque des revendications 1 à 14, **caractérisé en ce que** dans des régions partielles, il est muni d'une couche fonctionnelle (17) qui fait preuve d'une conductivité plus importante que le matériau de l'élément porteur (10).

**16.** Élément porteur selon l'une quelconque des revendications 1 à 15, **caractérisé en ce que** la plaque (11) est divisée par au moins une encoche (14), sur un côté longitudinal de l'encoche (14), une première partie de (11a) de la plaque étant en liaison conductrice d'électricité avec la source de chaleur (40) et sur le côté longitudinal opposé de l'encoche (14), une deuxième partie (11b) de la plaque (11) étant en liaison conductrice d'électricité avec le dissipateur thermique (30).

17. Élément porteur selon la revendication 16, **caractérisé en ce que** la première et la deuxième parties (11a, b) de la plaque (11) sont reliées l'une à l'autre par au moins un listel (15) chevauchant l'encoche (14).

18. Élément porteur selon la revendication 17, **caractérisé en ce que** chaque base de listel (15a, 15b) est conçue sur la première et/ou la deuxième partie (11a, b) de la plaque (11) en tant que section compensatrice (16) élastique.

19. Élément porteur selon la revendication 18, **caractérisé en ce que** la matière thermoélectrique active (22) de l'élément thermoélectrique (20) en couche mince se trouve exclusivement dans une région au-dessus de l'encoche (14), par rapport à la surface de la plaque.

20. Élément porteur selon l'une quelconque des revendications 15 à 19, **caractérisé en ce que** la plaque (11) est de forme annulaire et est divisée par l'encoche (14) en deux anneaux de cercle (19a, b) concentriques.

21. Élément porteur selon l'une quelconque des revendications 1 à 19, **caractérisé en ce que** la plaque (11) est rectangulaire.

22. Élément porteur selon l'une quelconque des revendications 1 à 21, **caractérisé en ce que** le dissipateur thermique (30) et/ou la source de chaleur (40) comprend au moins un tube (31, 41) pour un caloporteur, auquel est relié l'élément porteur (10).

23. Élément porteur selon la revendication 22, **caractérisé en ce que** chaque tube (31, 41) s'étend à la perpendiculaire du plan de la plaque de l'élément porteur (10).

24. Module (50) comprenant un ou plusieurs éléments porteurs (10) de conception identique selon l'une quelconque ou plusieurs des revendications 1 à 23 et une source de chaleur (40) commune et/ou un dissipateur thermique (30) commun, sur laquelle/lequel sont reliés tous les éléments porteurs (10).

25. Module (50) selon la revendication 24, **caractérisé en ce que** le dissipateur thermique (30) et/ou la source de chaleur (40) comprend au moins un tube (31, 41) pour la circulation d'un caloporteur, auquel sont reliés tous les éléments porteurs.

26. Module selon la revendication 25, **caractérisé en ce que** chaque tube (31, 41) s'écoule à la transversale de la surface de chaque élément porteur (10).

**Vorderansicht:**

**Figur 1b**

**Seitenansicht:**

Thermomechanische Ausdehnung

Verschiebung

≥ 0,5 mm

≥ 0,5 mm

**Figur 1a**

**Figur 2**

16

**Figur 3a**

16a    16b

**Figur 3 b**

**Figur 4 b**

**Figur 4a**

Figur 5 a

Figur 5 b

20

Vorderansicht    Seitenansicht

**Figur 5 c**

**Figur 6a**

**Figur 6 b**

**Figur 7**

**Figur 8 a**

**Figur 8 b**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006031164 A1
- DE 10122679 A1
- DE 102008032856 A1
- DE 102011008378 A1